# EUROPEAN PATENT APPLICATION

(11) **EP 4 618 004 A1**
(43) Date of publication of application: **17.09.2025**
(21) Application number: 23889196.4
(22) Date of filing: 10.11.2023
(51) Int. Cl.: G06T 7/00

(54) **DEVICE AND METHOD FOR DETERMINING TYPE OF DEFECT, AND RECORDING MEDIUM HAVING COMMANDS RECORDED THEREON**

(30) Priority: 10.11.2022 KR 20220149255
(71) Applicant: Koh Young Technology Inc., Seoul 08588 (KR)
(72) Inventor: YOO, Yong Ho, Daejeon 34140 (KR); LEE, Jae Hwan, Seoul 04574 (KR); LEE, Geon Nyeong, Seongnam-si Gyeonggi-do 13597 (KR); KANG, Jin Man, San Diego, California 92129 (US)
(74) Representative: Meissner Bolte Partnerschaft mbB
(86) International application number: PCT/KR2023/018039
(87) International publication number: WO 2024/101940

(57) **Abstract**

A technique for determining a type of defect is disclosed. An apparatus according to one embodiment of the present disclosure includes one or more processors, and one or more memories configured to store a machine learning model and commands that cause the one or more processors to perform operations when executed by the one or more processors, wherein the one or more processors acquire measurement data indicating a state of solder paste printed on a plurality of printed circuit boards (PCBs) by a screen printer, generate a plurality of input images that correspond one-to-one to the plurality of PCBs and indicate whether the measurement data satisfies a predetermined standard, the plurality of input images including a first input image corresponding to a first PCB and a plurality of second input images corresponding respectively to the PCBs on which the solder paste is sequentially printed before the first PCB, and determine a type of defect that has occurred in at least one of the screen printer or the first PCB from the first input image and the plurality of second input images based on the machine learning model.

## Description

### TECHNICAL FIELD

The present disclosure relates to a technique for determining a type of defect.

### BACKGROUND

A process of printing solder paste on a printed circuit board (PCB) can be performed by a screen printer. During the solder paste printing process, when at least one of the screen printer and the PCB is faulty, defect may occur in the PCB. However, based on the defect occurring on a single PCB, it may be difficult to accurately determine whether the defect occurred due to the screen printer or the PCB.

### SUMMARY

Various embodiments of the present disclosure provide a technique for determining a type of defect.

An apparatus according to one embodiment of the present disclosure may include one or more processors, and one or more memories configured to store a machine learning model and commands that cause the one or more processors to perform operations when executed by the one or more processors, wherein the one or more processors may acquire measurement data indicating a state of solder paste printed on a plurality of printed circuit boards (PCBs) by a screen printer, generate a plurality of input images that correspond one-to-one to the plurality of PCBs and indicate whether the measurement data satisfies a predetermined standard, the plurality of input images including a first input image corresponding to a first PCB and a plurality of second input images corresponding respectively to the PCBs on which the solder paste is sequentially printed before the first PCB, and determine a type of defect that has occurred in at least one of the screen printer or the first PCB from the first input image and the plurality of second input images based on the machine learning model.

In one embodiment, the one or more processors may generate first data obtained by analyzing the state of the solder paste printed on the plurality of PCBs based on a time-series change between patterns of the first input image and each of the plurality of second input images, generate second data obtained by analyzing a position of the solder paste printed on the plurality of PCBs based on the patterns of the first input image and each of the plurality of second input images, and determine the type of defect that has occurred in the at least one of the screen printer or the first PCB based on the first data and the second data.

In one embodiment, the one or more processors may determine that defect has occurred in the screen printer when a same pattern periodically appears between the first input image and the plurality of second input images based on the first data, and determine that defect has occurred in the first PCB when a same pattern does not periodically appear between the first input image and the plurality of second input images.

In one embodiment, the one or more processors may determine the type of defect that has occurred in the screen printer from the second data based on the machine learning model in response to determining that a defect has occurred in the screen printer.

In one embodiment, the first data may include data indicating whether a same pattern appears between the first input image and the plurality of second input images and data indicating a period in which the same pattern appears, and the second data may include data about shapes of the patterns of the first input image and each of the plurality of second input images.

In one embodiment, the one or more processors may divide the measurement data into a plurality of pieces of data each corresponding to one PCB, generate a plurality of images indicating whether the solder paste printed on each PCB satisfies the predetermined standard based on the plurality of pieces of divided data, and generate the plurality of input images by changing the size of the plurality of images to a predetermined size.

In one embodiment, the one or more processors may determine a first probability of a first defect type occurring in the screen printer or the first PCB and a second probability of a second defect type occurring in the screen printer or the first PCB, based on patterns of the first input image and each of the plurality of second input images.

In one embodiment, the apparatus may further include a communication circuit communicatively connected to a PCB inspector, wherein the communication circuit may acquire the measurement data indicating the state of the solder paste printed on the plurality of PCBs from the PCB inspector.

In one embodiment, the type of defect may include at least one of a squeeze blade defect, a squeeze blade fixation defect, a stencil bottom support defect, a defect due to poor clamp contact and damage, a defect due to neglect of solder paste and poor kneading of solder paste, a defect due to lack of solder paste in a specific area, a defect due to poor contact between stencil and board, a defect in stencil design, or a defect in board design.

In one embodiment, the one or more processors may train the machine learning model through a plurality of images having at least one pattern determined based on whether the solder paste printed on each of the plurality of PCBs classified according to at least one type of defect of the screen printer satisfies the predetermined standard.

In one embodiment, the machine learning model may be trained based on whether solder paste printed on each of learning PCBs having different sizes and shapes satisfies the predetermined standard.

In one embodiment, the machine learning model may be a transformer model.

A method according to another embodiment of the present disclosure may include acquiring measurement data indicating a state of solder paste printed on a plurality of PCBs by a screen printer, generating a plurality of input images that correspond one-to-one to the plurality of PCBs and indicate whether the measurement data satisfies a predetermined standard, the plurality of input images including a first input image corresponding to a first PCB and a plurality of second images corresponding respectively to the PCBs on which the solder paste is sequentially printed before the first PCB, and determining a type of defect that has occurred in at least one of the screen printer or the first PCB from the first input image and the plurality of second input images based on a machine learning model stored in one or more memories.

In one embodiment, the determining the type of defect may include generating first data obtained by analyzing the state of the solder paste printed on the plurality of PCBs based on a time-series change between patterns of the first input image and each of the plurality of second input images, generating second data obtained by analyzing a position of the solder paste printed on the plurality of PCBs based on the patterns of the first input image and each of the plurality of second input images, and determining the type of defect that has occurred in the at least one of the screen printer or the first PCB based on the first data and the second data.

In one embodiment, the determining the type of defect may include determining that a defect has occurred in the screen printer when a same pattern periodically appears between the first input image and the plurality of second input images based on the first data, and determining that a defect has occurred in the first PCB when a same pattern does not periodically appear between the first input image and the plurality of second input images.

In one embodiment, the determining the type of defect may include determining the type of defect that has occurred in the screen printer from the second data based on the machine learning model in response to determining that a defect has occurred in the screen printer.

In one embodiment, the first data may include data indicating whether a same pattern appears between the first input image and the plurality of second input images and data indicating a period in which the same pattern appears, and the second data may include data about shapes of the patterns of the first input image and each of the plurality of second input images.

In one embodiment, the determining the type of defect may further include determining a first probability of a first defect type occurring in the screen printer or the first PCB and a second probability of a second defect type occurring in the screen printer or the first PCB, based on patterns of the first input image and each of the plurality of second input images.

In one embodiment, the method may further including training the machine learning model through a plurality of images having at least one pattern determined based on whether the solder paste printed on each of the plurality of PCBs classified according to at least one type of defect of the screen printer satisfies the predetermined standard.

In a non-transitory computer-readable recording medium recording commands that cause one or more processors to perform operations when executed by one or more processors according to still another embodiment of the present disclosure, the commands cause the one or more processors to perform operations of: acquiring measurement data indicating a state of solder paste printed on a plurality of PCBs by a screen printer; generating a plurality of input images that correspond one-to-one to the plurality of PCBs and indicate whether the measurement data satisfies a predetermined standard, the plurality of input images including a first input image corresponding to a first PCB and a plurality of second images corresponding respectively to the PCBs on which the solder paste is sequentially printed before the first PCB, and determining a type of defect that has occurred in at least one of the screen printer or the first PCB from the first input image and the plurality of second input images based on a machine learning model stored in one or more memories.

According to the present disclosure in some embodiments, it is possible to accurately determine a type of defect that has occurred in at least one of a screen printer or a PCB.

### BRIEF DESCRIPTION OF DRAWINGS

FIG. 1 is a block diagram schematically illustrating a configuration of an apparatus for determining a type of defect according to an embodiment of the present disclosure.
FIG.2 illustrates a process in which an apparatus according to an embodiment of the present disclosure converts measurement data into an input image.
FIG. 3 is a configuration diagram schematically illustrating a configuration of a machine learning model according to an embodiment of the present disclosure.
FIG. 4 illustrates an embodiment in which an apparatus according to an embodiment of the present disclosure determines a type of defect based on a plurality of input images.
FIG. 5 illustrates an embodiment in which an apparatus according to an embodiment of the present disclosure determines a type of defect based on a plurality of input images.
FIG. 6 illustrates an embodiment in which an apparatus according to an embodiment of the present disclosure determines a type of defect based on a plurality of input images.
FIG. 7 illustrates an embodiment in which an apparatus according to an embodiment of the present disclosure determines various types of defects based on a plurality of input images.
FIG. 8 is a flowchart illustrating a method for determining a type of defect using a plurality of printed circuit boards (PCBs) according to an embodiment of the present disclosure.
FIG. 9 is a flowchart illustrating an embodiment in which an apparatus according to an embodiment of the present disclosure determines a type of a defeat based on first data and second data.

### DETAILED DESCRIPTION

Various embodiments described herein are illustrated for the purpose of clarifying the technical idea of the present disclosure, and are not intended to limit the present disclosure to any specific embodiment. The technical idea of the present disclosure includes various modifications, equivalents, alternatives and embodiments selectively combined from all or part of individual embodiments described in the present document. Further, the scope of the technical idea of the present disclosure is not limited to the various embodiments described below and the detailed description thereof.

In the present disclosure, terms including technical or scientific terms may have meanings that are generally understood by those of ordinary skill in the art to which this disclosure belongs, unless otherwise defined.

The expressions "include," "provided with," "have" and the like used herein should be understood as open-ended terms connoting the possibility of inclusion of other embodiments, unless otherwise mentioned in a phrase or sentence including the expressions. That is, such expressions should be understood as open-ended terms that include the possibility of including other embodiments.

In the present disclosure, the singular of an expression may include the meaning of the plural of the expression unless the context clearly indicates otherwise, and the same applies to singular forms of expressions set forth in the claims.

In the present disclosure, the expressions "1^{st}," "2^{nd}," "first," "second," and the like are used to distinguish one object from another in referring to a plurality of same objects unless otherwise indicated in the context, and do not limit the order or importance of the objects.

In the present disclosure, the expressions "A, B and C," "A, B or C," "A, B and/or C," "at least one of A, B, and C," "at least one of A, B, or C," "at least one of A, B, and/or C," and so on may be used to refer to each listed item or any possible combination of the listed items may be provided. For example, the expression "at least one of A and B" may be used to refer to all of (1) A, (2) B, and (3) A and B.

The term "unit" used in these embodiments means a software component or hardware component, such as a field-programmable gate array (FPGA) and an application specific integrated circuit (ASIC). However, a "unit" is not limited to software and hardware and it may be configured to be an addressable storage medium or may be configured to run on one or more processors. For example, a "unit" may include components, such as software components, object-oriented software components, class components, and task components, as well as processors, functions, attributes, procedures, subroutines, segments of program codes, drivers, firmware, micro-codes, circuits, data, databases, data structures, tables, arrays, and variables.

The expression "based on" used herein is used to describe one or more factors that influences a decision, an action of judgment or an operation described in a phrase or sentence including the relevant expression, and this expression does not exclude an additional factor influencing the decision, the action of judgment or the operation.

In the present disclosure, the expression that a component (e.g., a first component) is "connected" or "coupled" to another component (e.g., a second component) may mean that the first component is connected or coupled to the second component not only directly, but also via another new component (e.g., a third component).

In the present disclosure, the expression "configured to . . . " is intended to encompass, depending on the context, the meanings of "set to . . . ", "having performance of . . . ", "altered to... ", "made to... ", "enabled to...", and the like. The corresponding expression is not limited to the meaning "specifically designed in hardware." For example, a processor configured to perform a specific operation may mean a generic-purpose processor that can perform the specific operation by executing software.

Various embodiments of the present disclosure will now be described with reference to the accompanying drawings. In the accompanying drawings and the descriptions of the drawings, substantially equivalent elements may be given the same reference numerals. In the following description of the various embodiments, a description of the same or corresponding components may be omitted. However, this does not mean that the components are not included in the embodiment.

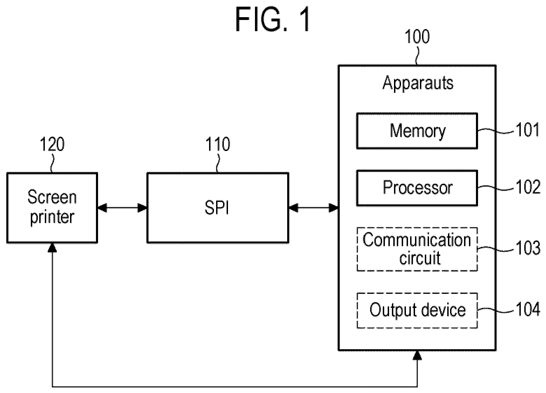

FIG. 1 is a block diagram schematically illustrating a configuration of an apparatus 100 for determining a type of defect according to an embodiment of the present disclosure. In one embodiment, the apparatus 100 may include a memory 101, a processor 102, and/or a communication circuit 103. In addition, the apparatus 100 may further include an output device 104 for outputting results processed by the processor 102. In some embodiments, at least one of these components of the apparatus 100 may be omitted, or other components may be added to the apparatus 100. In some embodiments, additionally or alternatively, some components may be integrated and implemented, or may be implemented as a single entity or a plural entities.

At least some of the internal and external components of the apparatus 100 (e.g., the memory 101, the processor 102, and the communication circuit 103) may be connected to each other through a bus, a general purpose input/output (GPIO), a serial peripheral interface (SPI), a mobile industry processor interface (MIPI), or the like to exchange data and/or signals.

The apparatus 100 may have various types. For example, the apparatus 100 may be a portable communication device, a computer device, a portable multimedia device, a wearable device, a home appliance device, or a device based on one or more combinations of the above-described devices. The apparatus 100 of the present disclosure is not limited to the devices described above.

The processor 102 may drive software to control at least one component of the apparatus 100 connected to the processor 102. In addition, the processor 102 may perform various operations related to the present disclosure, such as calculation, processing, data generation, and processing. In addition, the processor 102 may load data from the memory 101 or store data in the memory 101.

The memory 101 may store various data. The data stored in the memory 101 is data acquired, processed, or used by at least one component of the apparatus100 and include software. The memory 101 may include a volatile and/or non-volatile memory.

The communication circuit 103 may perform wireless or wired communication between the apparatus 100 and other external electronic devices. For example, the communication circuit 103 may perform wireless communication according to a method such as long-term evolution (LTE), LTE Advance (LTE-A), code division multiple access (CDMA), wideband CDMA (WCDMA), wireless broadband (WiBro), wireless fidelity (Wi-Fi), Bluetooth, near field communication (NFC), global positioning system (GPS), or global navigation satellite system (GNSS). For example, the communication circuit 103 may perform wired communication according to a method such as universal serial bus (USB), high definition multimedia interface (HDMI), recommended standard 232 (RS-232), or plain old telephone service (POTS). The communication circuit 103 may be omitted from the apparatus 100 depending on the embodiment.

Hereinafter, a process using surface mount technology (SMT), in which a screen printer 120 prints a printed circuit board (PCB), will be briefly described. The screen printer 120 may include a workbench, a stencil (or metal mask), and a squeeze blade. When a PCB is provided in the screen printer 120 and fixed on the workbench, the stencils may be arranged to overlap on the PCB. The stencil may include a plurality of openings to allow solder paste to be printed only on a fixed area of the PCB. After the stencil is aligned on the PCB so that the openings of the stencil are located on the pad of the corresponding PCB, the screen printer 120 may print the solder paste on the stencil, push the solder paste into the opening of the stencil using a squeeze blade, and solder the solder paste onto the pad on the PCB. Next, the screen printer separates the stencil and the PCB.

The shape of the solder paste printed on the PCB may be inspected through solder paste inspection (SPI) technology. The SPI technology is a technology that acquires a two-dimensional or three-dimensional image of the solder paste printed on the PCB through optical technology and inspects the shape of the solder paste printed on the PCB from the acquired image.

During the printing process of the PCB as described above, when various types of defects occur in the screen printer 120 or there is a design defect in the printed circuit board, the quality of the PCB may deteriorate. In one embodiment, at least one defect type of the screen printer 120 may be at least one defect type that may cause an abnormality in the solder paste printed on the PCB, among various defect types that can occur in the screen printer 120. For example, the at least one defect type of the screen printer 120 may include at least one of a squeeze blade defect of the screen printer 120, a squeeze blade fixation defect (e.g., a defect in the screw fastening to fix the squid blade, etc.), a defect in the support of the screen printer 120, a defect in the table of the screen printer 120, a defect due to poor grid lock setting when using a grid lock as the support), a defect due to the state of the solder paste supplied from the screen printer 120, for example, neglect of the solder paste, a defect due to poor kneading of the solder paste, a defect due to a lack of the solder paste supplied from the screen printer 120, or a defect due to poor stencil contact. In one embodiment, design defects of the PCB may include bending and distortion of the PCB, poor impedance, etc.

However, this is for illustrative purposes only and is not limited thereto, and various defect types of the screen printer 120 that may cause abnormalities in the solder paste printed on the PCB may be included in the at least one defect type of the screen printer 120.

A solder paste inspector (SPI) 110 (hereinafter, referred to as an inspector) may inspect a PCB and generate various data related to the quality of the PCB. For example, the SPI 110 may acquire data including at least one of whether the solder paste printed on a plurality of pads of the PCB has an excessive volume or insufficient volume, a standard deviation of the printed solder paste, a degree (offset) to which the PCB and stencil deviate from an aligned position, and capability of process (Katayori, CPK) for PCB processing. Hereinafter, data generated by the SPI 110 by inspecting the PCB is referred to as measurement data. The SPI 110 may inspect a plurality of PCBs and generate measurement data corresponding to each PCB.

The processor 102 may communicate with the SPI 110 using the communication circuit 103 and receive measurement data from the SPI 110. For example, the processor 102 may receive a plurality of pieces of measurement data for a plurality of PCBs from the SPI 110 and store the received data in the memory 101. The processor 102 may determine the type of defect that has occurred in the screen printer 120 or the PCB using the acquired measurement data. According to an embodiment, the processor 102 may use the acquired measurement data to determine whether a problem has occurred in the quality of the PCB. When it is determined that the problem has occurred in the quality of the PCB, the processor 102 may use the acquired measurement data to determine a type of defect that has occurred in the screen printer 120 or the PCB.

Hereinafter, a process in which the processor 102 determines a type of defect that has occurred in the screen printer 120 or the PCB will now be described.

The processor 102 may generate an image indicating whether the acquired measurement data satisfies a predetermined standard. According to one embodiment, the input image may be an image indicating whether the solder paste printed on each of the plurality of pads included in the PCB has an excessive volume or an insufficient volume. Hereinafter, the image indicating whether the solder paste printed on the pads of the PCB has an excessive volume or an insufficient volume is referred to as an input image. For example, based on the measurement data, the processor 102 may generate an input image including a pattern indicating a position on the PCB of the pad where the excessive volume or the insufficient volume of the solder paste is generated among the plurality of pads of the PCB. When the excessive volume or the insufficient volume of the solder paste is not generated on the PCB, the pattern may not appear in the input image corresponding to the PCB. For example, the input image corresponding to the PCB where the excessive volume or the insufficient volume of the solder paste is not generated may be a black (or white) image. However, the input image is not limited thereto, and may be an image representing various states of the solder paste printed on the PCB included in the measurement image.

The processor 102 may generate an input image with a predetermined size while maintaining the horizontal and vertical length ratio of the PCB. When the input image has the same size as the actual size of the PCB, the size of the data processed by the processor 102 may become excessively large and thus, the processor 102 may generate an input image with a size smaller than the actual size of the PCB. According to one embodiment, the processor 102 may generate input images corresponding to PCBs having various sizes and patterns. For example, the processor 102 may generate a first input image corresponding to a first PCB having a first area and a first set of pads, and generate a second input image corresponding to a second PCB having a second area different from the first area and a second set of pads different from the first set of pads. The areas of the first PCB and the second PCB may be different, but the areas of the first input image and the second input image may be the same.

The memory 101 may store a machine learning model. The machine learning model may be trained to derive at least one value indicating a relevance between the input image and at least one defect type of the screen printer 120 or the PCB. The machine learning model may be, for example, a transformer model. In addition, the machine learning model may be stored in the memory 101 of an external device (e.g., an external server, etc.) linked to the processor 102 in a wired or wireless manner. In this case, the processor 102 may transmit and receive information for determining a defect type related to at least one solder paste in which an abnormality has been detected with an external device connected in a wired or wireless manner.

The at least one value indicating the relevance between the at least one defect type generated by the processor 102 and the input image may be a probability value. For example, the at least one value may be indicated as having a% of relevance to a first defect type of the screen printer 120 or the PCB and b% of relevance to a second defect type of the screen printer 120 or the PCB. That is, the processor 102 may determine a plurality of types of defects that may have occurred in the screen printer 120 or the PCB based on the input image. However, this is only for the purpose of explanation and is not limited thereto, and various values that can indicate relevance may be used.

The machine learning model stored in the memory 101 may be trained through a plurality of input images classified according to at least one defect type of the screen printer 120 or the PCB. For example, the machine learning model may be trained through a plurality of input images classified as a first defect type of the screen printer 120 or the PCB and a plurality of input images classified as a second defect type of the screen printer 120. When a plurality of input images are input, the machine learning model trained in this way may output a value indicating relevance between the input image and at least one of the first defect type or the second defect type.

The processor 102 may acquire a plurality of pieces of measurement data for a plurality of PCBs sequentially printed, and generate an input image corresponding respectively to the plurality of PCBs based on the plurality of pieces of measurement data. For example, the processor 102 may generate a first input image for a first PCB that was printed last, and a plurality of second input images for a plurality of second PCBs that were printed before the first PCB. According to one embodiment, the plurality of second input images may be used to detect abnormalities in solder pastes printed on the first PCB. For example, the processor 102 may determine the type of defect that has occurred in the screen printer 120 or the first PCB in the printing process of the first PCB based on a time-series change of the first input image and the plurality of second input images.

The processor 102 may generate, from the first input image and the plurality of second input images, first data indicating a time-series change of an input image pattern and second data indicating a position where an excessive volume or an insufficient volume of the solder paste in the plurality of PCBs is generated. The processor 102 may generate the first data by analyzing pattern changes in the input images of the plurality of PCBs sequentially input to the screen printer 120 in a time-series manner. The processor 102 may generate the second data indicating the position where the excessive volume or the insufficient volume of the solder paste is generated on the PCB based on the pattern shown in each of the plurality of input images.

The processor 102 may use the machine learning model to determine the type of defect that has occurred in the screen printer 120 or the PCB based on the first input image, the plurality of second input images, the first data, and the second data. The machine learning model may acquire the first input image and the plurality of second input images, and derive at least one value indicating a relevance between the input image and at least one defect type of the screen printer 120 or the PCB. According to one embodiment, the processor 102 may determine that a defect has occurred in the screen printer 120 when the same pattern periodically appears in the first input image and the plurality of second input images. According to one embodiment, when the same pattern appears in both the first input image and the plurality of second input images, it may be determined that the defect has occurred in the screen printer 120 and the same problem continues to occur. For example, when the same pattern appears in both the first input image and the plurality of second input images, the processor 102 may determine that a support defect has occurred in the screen printer 120. For example, when the same pattern appears in the first input image and odd-numbered (or even-numbered) input images of the plurality of second input images, the processor 102 may determine that a squeeze blade defect has occured in the screen printer 120. According to another embodiment, the processor 102 may determine that a temporary defect has occurred in the first PCB or the screen printer when the same pattern does not appear periodically in the first input image and the plurality of second input images. For example, when a pattern appears only in the first input image and does not appear in the plurality of second input images, the processor 102 may determine that a design defect has occurred in the first PCB. The temporary defect refers to a defect that occurs only while printing a predetermined number of PCBs, and may occur in the first PCB or the screen printer for various reasons. For example, the temporary defect may occur when there is a design defect in the first PCB or when the solder is printed in a state where the solder is not sufficiently kneaded in the screen printer. When the solder is not sufficiently kneaded in the screen printer, several printings may be performed and the temporary defect may not occur after the solder is kneaded.

According to an embodiment, the processor 102 may train the machine learning model using the plurality of input images and data to which the type of defect corresponding to each input image is mapped. According to one embodiment, the training of the machine learning model may be done offline, and the plurality of input images and the data to which the defect type corresponding to each input image is mapped may be acquired through the previously performed printing process of the circuit board.

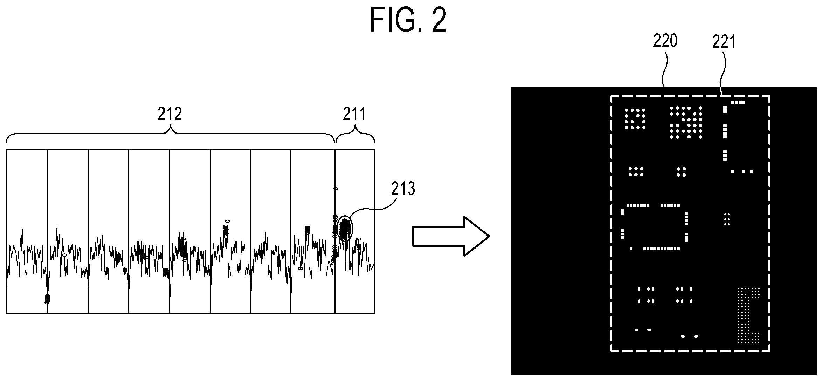

FIG. 2 illustrates a process in which an apparatus according to an embodiment of the present disclosure converts measurement data into an input image. The measurement data may be generated by combining information on a plurality of PCBs in time series according to the order in which the plurality of PCBs are inspected by an inspector. The measurement data may include data measured for each of a plurality of solder pastes printed on each PCB. For example, the measurement data may include data on printing amounts of the plurality of solder pastes on a plurality of pads included in each PCB and data indicating whether the solder pastes have an excessive volume or an insufficient volume.

Hereinafter, the measurement data for the first PCB will be referred to as first measurement data 211, and the measurement data for the plurality of second PCBs will be referred to as second measurement data 212. For example, the first measurement data 211 and the second measurement data 212 may be data in which the plurality of solder pastes printed on one PCB are aligned according to an area between the printed pads. For example, the first measurement data 211 may be data aligned in order from data for the solder paste printed on the pad with the largest area on the first PCB to data for the solder paste printed on the pad with the smallest area. However, this is only for the purpose of explanation and is not limited thereto. Information measured for each of the plurality of solder pastes included in the first measurement data 211 and the second measurement data 212 may be aligned according to identification information of the pads on which the plurality of solder pastes are printed, may be aligned in a time-series manner according to the inspection order of each of the plurality of solder pastes, or may be aligned randomly without any separate criteria.

The processor may compare the first measurement data 211 and the second measurement data 212. The processor may determine a difference between the first measurement data 211 and the second measurement data 212 by comparing the first measurement data 211 and the second measurement data 212. In addition, the processor may determine a portion 213 that is outside a predetermined range from the determined difference. The processor may determine that an excessive volume or an insufficient volume of the solder paste printed on at least one pad corresponding to the determined portion 213 which is outside the predetermined range has been generated.

The processor may update the second measurement data 212 by adding the first measurement data 211 to the second measurement data 212 after the inspection of the first PCB is completed. For example, the processor may update the second measurement data 212 only when the excessive volume or insufficient volume in the plurality of solder pastes printed on the first PCB is not generated. As another example, the processor may update the second measurement data 212 even when the excessive volume or insufficient volume is generated in at least one of the plurality of solder pastes printed on the first PCB.

The processor may convert the first measurement data 211 and the second measurement data 212 into an input image 220 to be input to a machine learning model. According to one embodiment, based on the measurement data, the processor may generate the input image 220 including a pattern 221 indicating a position on the PCB of a pad where the excessive volume or insufficient volume of the solder paste is generated among a plurality of pads of the PCB. For example, the input image 220 may have a shape of the corresponding PCB and may include the pattern 221 indicating the state of the solder paste printed on the pad included in the PCB.

According to one embodiment, the processor may determine the pattern 221 of the input image 220 depending on whether the excessive volume or insufficient volume of the solder paste is generated. For example, when the excessive volume or insufficient volume of the solder paste is not generated on all the pads of the PCB, the processor may determine that the input image 220 has one color (e.g., black) without the separate pattern 221. On the other hand, when the excessive volume or insufficient volume of the solder paste is generated in some pads of the PCB, the processor may determine that the pattern 221 of the input image 220 is displayed by distinguishing the position of the pad where the excessive volume or insufficient volume of the solder paste is generated. According to one embodiment, when determining the pattern 221 of the input image 220, the processor may display the excessive volume of the solder paste and the insufficient volume of the solder paste in different colors. When the excessive volume of the solder paste is generated on the first pad of the PCB and the insufficient volume of the solder paste is generated on the second pad, the processor may display the position of the first pad in the input image 220 as a first color, and display the position of the second pad as a second color that is distinct from the first color.

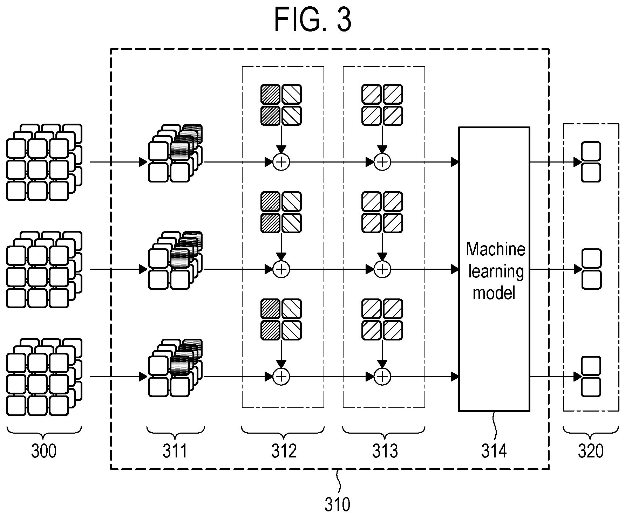

FIG. 3 is a configuration diagram schematically illustrating a configuration of a machine learning model according to one embodiment of the present disclosure. The processor may input a plurality of input images 300 generated as described in FIG. 2 to a machine learning model 314. The processor may use the machine learning model 314 to determine the type of defect that has occurred in at least one of the screen printer or the PCB based on the plurality of input images 300.

The processor may use a detection with transformer (DETR) structure 310 including the machine learning model 314 to determine the type of defect that has occurred in at least one of the screen printer or the PCB. For example, the machine learning model 314 may be the transformer model. The processor may input the plurality of input images 300 to the machine learning model 314, and acquire information 320 on the type of defect that has occurred in the at least one of the screen printer or the PCB as a result of processing the plurality of input images 300 in the machine learning model 314.

The processor may determine the plurality of input images 300 to be input to the machine learning model 314. The processor may analyze changes over time in the plurality of input images 300 to accurately determine the type of the defect occurring in the at least one of the screen printer or the PCB. According to one embodiment, the processor may input a predetermined number (e.g., 9) of input images 300 into the machine learning model 314. For example, to analyze a defect in at least one of the screen printer or the PCB that affected the process of printing the first PCB, the processor may use the input images 300 for a plurality of second PCBs printed by the screen printer before the first PCB is printed. The processor may further increase the number of second PCBs in order to increase the accuracy of determining the type of defect occurring in the at least one of the screen printer or the PCB. According to one embodiment, the processor may determine the number of second PCBs based on an external input.

The processor may convert the plurality of input images 300 into a feature map form 311 that can be processed by the machine learning model 314. The processor may generate first data 312 about time-series changes in the plurality of input images 300. According to one embodiment, the first data 312 may be data obtained by analyzing the time-series changes in the patterns of the plurality of input images 300. For example, the first data 312 may include data about whether the same pattern appears among the plurality of input images 300 and the period in which the same pattern appears.

The processor may generate second data 313 about the shape of the pattern of the plurality of input images 300. According to one embodiment, the second data 313 may be data about the position of a pad where the excessive volume or insufficient volume of the solder paste is generated on the PCB, based on the pattern of each of the plurality of input images 300.

The processor may input the input image converted into the feature map form 311 to the machine learning model 314 to determine the type of defect that has occurred in at least one of the screen printer or the PCB. For example, the machine learning model 314 may determine the type of defect in the at least one of the screen printer or the PCB that affected the printing process of the first PCB, based on the first data 312 and the second data 313.

The machine learning model 314 may determine whether the defect occurred in the screen printer or the PCB with reference to the first data 312, and output information 320 about the type of the defect. According to one embodiment, when the same pattern occurs repeatedly in the plurality of input images 300, it may be determined that a defect has occurred in the screen printer. For example, when the same pattern occurs in all the input images 300 or in the odd-numbered (or even-numbered) input images among the input images 300, it may be determined that a defect has occurred in the screen printer. For example, when the same pattern occurs in the odd-numbered (or even-numbered) input images among the input images 300, the machine learning model 314 may determine that a squeeze blade defect or a support defect has occurred. According to another embodiment, when the same pattern does not occur repeatedly in the plurality of input images 300, it may be determined that a temporary defect has occurred in the PCB or the screen printer. For example, when a specific pattern occurs in only one input image among the plurality of input images 300, the machine learning model 314 may determine that a design defect of the PCB has occurred.

According to one embodiment, the machine learning model 314 may accurately determine a type of defect that has occurred in the at least one of the screen printer or the PCB based on the second data 313. For example, when it is determined that the screen printer has a defect, the machine learning model 314 may determine, with reference to the second data 313, that the screen printer has a first defect type when the pattern is a first shape, and determine that the screen printer has a second defect type when the pattern is a second shape.

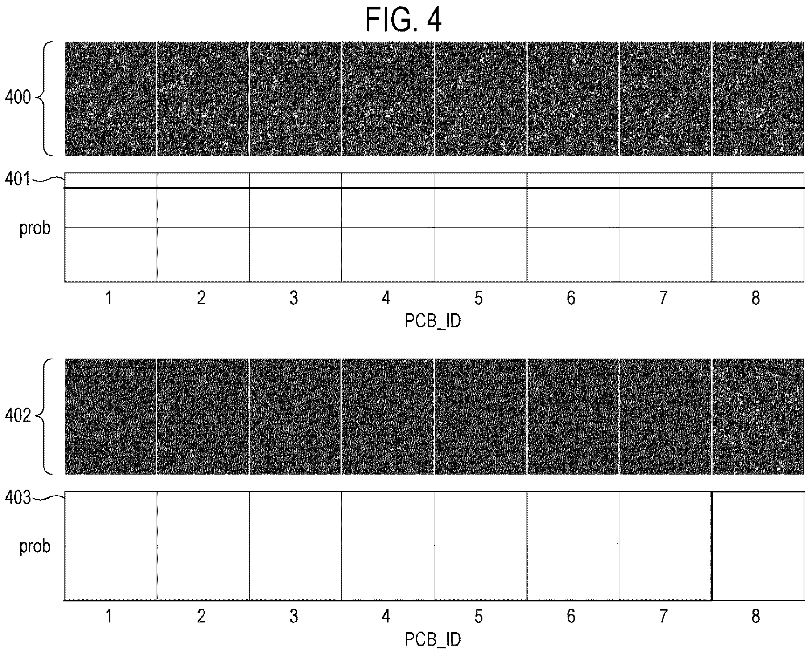

FIG. 4 illustrates an embodiment in which an apparatus according to one embodiment of the present disclosure determines a type of defect based on a plurality of input images. The processor may determine the type of defect based on the plurality of input images. The processor may determine the type of defect based on whether the same pattern appears repeatedly in a plurality of input images. FIG. 4 illustrates an embodiment of determining the type of defect using 8 input images, but the embodiment of the present disclosure is not limited thereto. In addition, among the plurality of input images 400 and 402 in FIG. 4, the 8th PCB corresponding to the 8th input image will be described as the most recently printed PCB. According to one embodiment, the processor may acquire information about the type of defect from the machine learning model 314, and generate graphs 401 and 403 representing the type of defect that has occurred on the screen print or the PCB when each PCB is printed using the acquired information.

The machine learning model 314 may determine the type of defect occurring in at least one of the screen printer or the PCB based on first data and second data generated based on the plurality of input images. For example, the plurality of input images 400 input to the machine learning model 314 may all have the same pattern. The machine learning model 314 may receive a plurality of input images 400, determine that a defect has occurred in the screen printer based on the first data, and determine that a defect in the support of the screen printer has occurred based on the second data.

According to another embodiment, the same pattern may not appear in the plurality of input images 402 input to the machine learning model 314. For example, among the plurality of input images 402 input to the machine learning model 314, a specific pattern may appear only in the 8th input image, and the pattern may not appear or a different pattern may appear in the remaining input images. The machine learning model 314 may determine that a temporary defect has occurred based on the first data and the second data. For example, it may be determined that the PCB has a design defect.

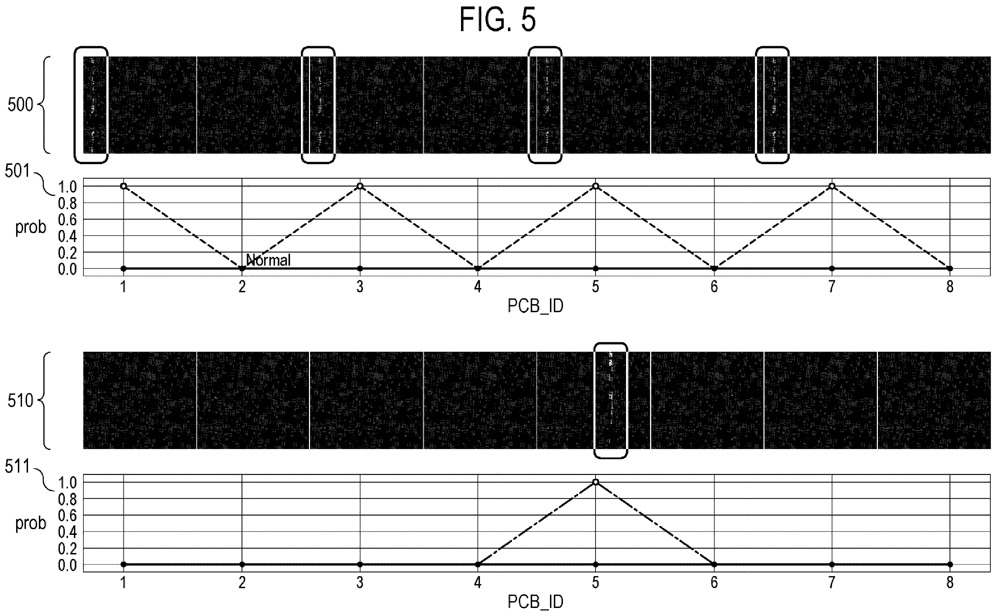

FIG. 5 illustrates an embodiment in which an apparatus according to one embodiment of the present disclosure determines a type of defect based on a plurality of input images. FIG. 5 shows an embodiment of determining a type of defect using eight input images, but the embodiment of the present disclosure is not limited thereto. In addition, among a plurality of input images 500 and 510, the 8th PCB corresponding to the 8th input image will be described as the most recently printed PCB.

The machine learning model 314 may determine a type of the defect occurring in at least one of the screen printer or the PCB based on the plurality of input images 500 and 510. Referring to FIG. 5, the same pattern may be periodically repeated in the plurality of input images 500. For example, the same pattern may appear repeatedly in each odd-numbered (or even-numbered) input image. The processor may generate first data and second data based on the plurality of input images 500. The first data may include information indicating that the same pattern appears repeatedly in the odd-numbered (or even-numbered) input images among the plurality of input images 500. The second data may include information indicating that patterns which repeatedly appear in the plurality of input images 500 have a vertically aligned shape. The machine learning model 314 may determine that a defect has occurred in the screen printer based on the first data, and determine the type of defect that has occurred in the screen printer based on the second data. For example, the machine learning model 314 may determine that the type of defect that has occurred in the screen printer is a squeeze blade defect. The machine learning model 314 may output information indicating that a squeeze blade defect has occurred in the screen printer, and the processor may acquire the corresponding information and determine that a squeeze blade defect has occurred.

Since the case where the pattern occurs in only one of the input images 510 input to the machine learning model 314 has been described in FIG. 4, a redundant description thereof will be omitted.

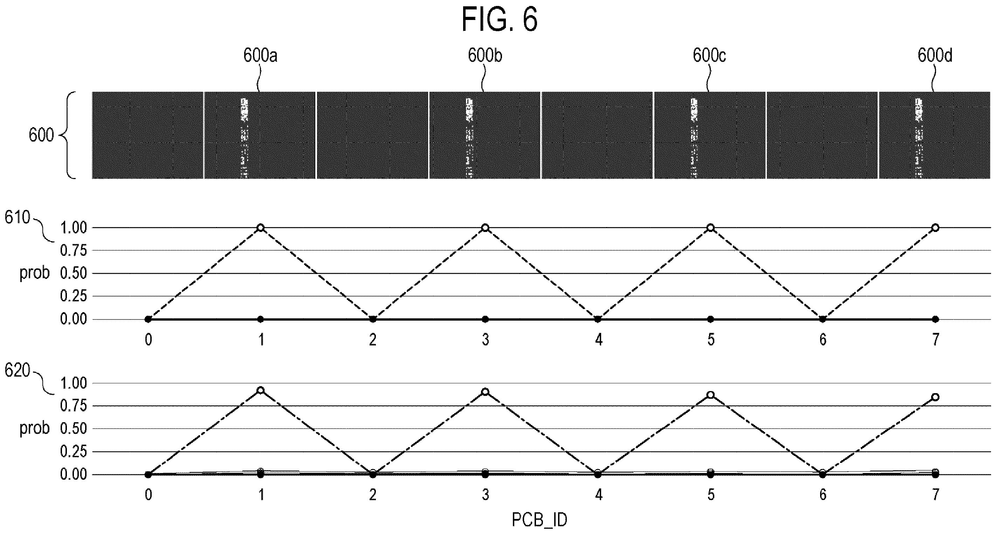

FIG. 6 illustrates an embodiment in which an apparatus according to one embodiment of the present disclosure determines a type of defect based on a plurality of input images. The processor may generate first data based on a time-series change in a pattern shown in a plurality of input images 600 and second data related to a shape of the pattern. The processor may use the machine learning model 314 to determine the type of defect based on the first data and the second data. Conventionally, because the type of defect was determined based on one input image, the type of defect could not be determined by considering the first data. However, by referring to the time-series change in the pattern included in the plurality of input images 600, it is possible to more accurately determine the type of defect. For example, referring to FIG. 6, when the same pattern occurs in the even-numbered input images 600a, 600b, 600c, and 600d among the plurality of input images 600, the type of defect may be accurately determined in consideration of the time-series change of the pattern. When the first data was considered in operation 610, it was incorrectly determined that the defect occurred due to neglect of the solder paste and poor kneading of the solder paste, but when the first data was considered in operation 620, it was determined that the defect occurred due to a squeeze blade defect. In other words, considering the time-series change in the pattern of each input image 600, the determination of the defect type of the processor for the same input images 600 may become more accurate.

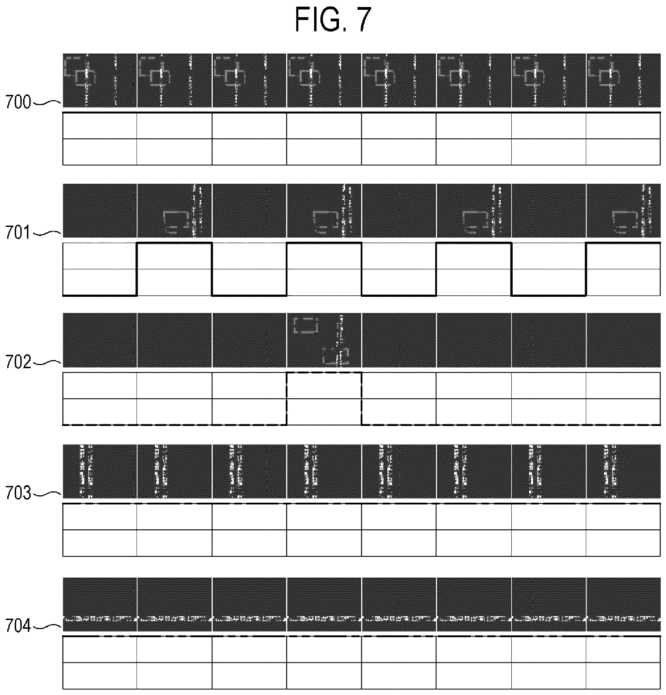

FIG. 7 illustrates an embodiment in which an apparatus according to one embodiment of the present disclosure determines a type of defect based on a plurality of input images. The processor may use a plurality of input images to determine various types of defects occurring in the screen printer and the PCB. For example, when a first pattern appears in the same way in all of the plurality of input images 700, the processor may use the machine learning model 314 to determine that a squeeze blade defect has occurred in the screen printer.

In another embodiment, when a second pattern appears in the even-numbered (or odd-numbered) input images among the plurality of input images 701, the processor may use the machine learning model 314 to determine that a squeeze blade defect has occurred in the screen printer.

In another embodiment, when a third pattern appears in only one input image among the plurality of input images 702, the processor may use the machine learning model 314 to determine that there is no defect in the screen printer but a design defect has occurred in the PCB.

In another embodiment, when a fourth pattern appears in the same way in all of the plurality of input images 703, the processor may use the machine learning model 314 to determine that a defect has occurred in the screen printer due to neglect of the solder paste and poor kneading of the solder paste.

In another embodiment, when a fifth pattern appears in the same way in all of the plurality of input images 704, the processor may use the machine learning model 314 to determine that a support defect has appeared in the screen printer.

Embodiments of the present disclosure are not limited to the above-mentioned examples, and the processor may determine that at least one of various types of defects has occurred based on the pattern appearing in the input image corresponding to the PCB and the time-series change in the pattern of the plurality of input images.

Various embodiments of the present disclosure may be implemented as software recorded in a machine-readable recording medium. The software may be software for implementing various embodiments of the present disclosure described above. The software may be inferred from various embodiments of the present disclosure by programmers of the technical field to which the present disclosure belongs. For example, the software may be commands (e.g., code or code segments) or a machine-readable program. The machine is an apparatus operable according to commands called from a recording medium, and may be, for example, a computer. In an embodiment, the machine may be the apparatus 100 according to embodiments of the present disclosure. In an embodiment, a processor of the machine may execute the called commands so as to cause the components of the machine to perform functions corresponding to the commands. In an embodiment, the processor may be the processor 102 according to embodiments of the present disclosure. The term "recording medium" may mean all kinds of recording media, which are stored with machine-readable data. The recording medium may include, for example, a ROM, a RAM, a CD-ROM, a magnetic tape, a floppy disk, an optical data storage, and the like. In an embodiment, the recording medium may be the memory 101. In an embodiment, the recording medium may be implemented in the form of being distributed in networked computer systems or the like. The software may be distributed and stored in computer systems or the like so as to be executed. The recording medium may be a non-transitory recording medium. The term "non-transitory recording medium" means a tangible medium regardless of whether data is stored therein semi-permanently or temporarily, and does not include a signal propagated in a transitory manner.

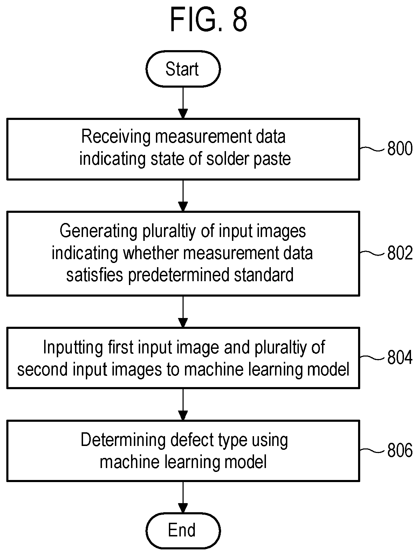

FIG. 8 is a flowchart illustrating a method of determining a type of defect using a plurality of PCBs according to one embodiment of the present disclosure. In operation 800, the apparatus 100 may receive measurement data indicating a state of a solder paste from the SPI 110. The apparatus 100 may acquire measurement data including information about the PCB printed by the screen printer 120 from the SPI 110. The measurement data may include information on the amount of the solder paste printed on the PCB and whether the solder paste has an excessive volume or insufficient volume. According to one embodiment, the measurement data may be data in which a plurality of solder pastes printed on one PCB are aligned according to the size of the area of the printed pad.

In operation 802, the apparatus 100 may generate a plurality of input images indicating whether the measurement data satisfies a predetermined standard. The input image may be an image indicating whether the solder paste printed on each of the plurality of pads included in the PCB has an excessive volume or insufficient volume. The apparatus 100 may compare first measurement data and second measurement data and determine a difference between the first measurement data and the second measurement data. The apparatus 100 may determine a portion that is outside a predetermined range from the determined difference. The apparatus 100 may determine that the excessive volume or insufficient volume has been generated in the solder paste printed on at least one pad corresponding to the portion outside the predetermined range. For example, based on the measurement data, the apparatus 100 may generate an input image including a pattern indicating the position on the PCB of a pad where the excessive volume or insufficient volume of the solder paste has been generated among a plurality of pads of the PCB. When the excessive volume or insufficient volume of the solder paste is not generated on the PCB, the pattern may not appear in the input image corresponding to the PCB.

According to one embodiment, the apparatus 100 may generate an input image having a predetermined size while having a width and height ratio that is the same as the width and height ratios of the PCB. The apparatus 100 may generate the size of the input image smaller than the size of the actual PCB for efficient data processing. According to one embodiment, the apparatus 100 may generate input images of PCBs having different sizes and pad sets.

In operation 804, the apparatus 100 may input a first input image and a plurality of second input images to the machine learning model 314. The memory of the apparatus100 may store the machine learning model 314. The machine learning model 314 may be trained to derive at least one value indicating a relevance between the input image and at least one defect type of the screen printer 120 or the PCB. The machine learning model 314 may be trained through the plurality of input images classified according to the at least one defect type of the screen printer 120 or the PCB. The machine learning model 314 may be, for example, a transformer model.

In operation 806, the apparatus 100 may use the machine learning model 314 to determine a defect type of at least one of the screen printer 120 or the PCB. The apparatus 100 may generate first data indicating a time-series change in the input image pattern from the first input image and the plurality of second input images, and second data indicating a position where the excessive volume or insufficient volume of the solder paste has been generated on the plurality of PCBs. The apparatus 100 may generate the first data by time-serially analyzing the pattern changes in the input images for the plurality of PCBs sequentially input to the screen printer 120. The apparatus 100 may generate the second data indicating the position where the excessive volume or insufficient volume of the solder paste has been generated on the PCB, based on the pattern shown in each of the plurality of input images.

The machine learning model 314 may acquire a first input image and a plurality of second input images, and derive at least one value indicating the relevance between the input image and at least one defect type of the screen printer 120 or the PCB. According to one embodiment, the apparatus 100 may determine that a defect has occurred in the screen printer 120 when the same pattern periodically appears in the first input image and the plurality of second input images. According to one embodiment, when the same pattern appears in both the first input image and the plurality of second input images, it may be determined that a defect has occurred in the screen printer 120 and the same problem continues to occur. According to another embodiment, the apparatus 100 may determine that a temporary defect has occurred in the first PCB or the screen printer when the same pattern does not appear periodically in the first input image and the plurality of second input images.

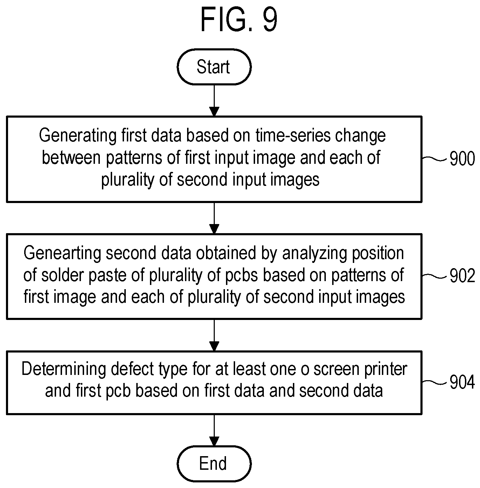

FIG. 9 is a flowchart illustrating an embodiment in which an apparatus according to one embodiment of the present disclosure determines a type of defect based on first data and second data. In operation 900, the apparatus 100 may generate the first data based on time-series changes between the patterns of the first input image and each of the plurality of second input images. For example, the first data may include information about whether the same pattern appears repeatedly among the plurality of input images and a period in which the same pattern appears repeatedly.

In operation 902, the apparatus 100 may generate the second data by analyzing the position of the solder paste on a plurality of PCBs based on the patterns of the first input image and each of the plurality of second input images. The second data may include information about a shape of the pattern included in the plurality of input images.

In operation 904, the apparatus 100 may determine a defect type for the at least one of the screen printer 120 or the first PCB based on the first data and the second data. The apparatus 100 may use the machine learning model 314 to determine the defect type based on the first data and the second data.

Although respective steps of the method or algorithm according to the present disclosure are illustrated in a sequential order in the flowcharts illustrated in FIGS. 8 and 9, the respective steps may be performed in an order in which the steps may optionally be combined by the present disclosure, in addition to being performed sequentially. The description with reference to the flowcharts is not intended to preclude a change or modification to the method or algorithm, and does not mean that any step is necessary or desirable. In an embodiment, at least some of the steps may be performed in parallel, repetitively, or heuristically. In an embodiment, at least some of the steps may be omitted, or other steps may be added.

Although the technical spirit of the present disclosure has been described by the examples described in some embodiments and illustrated in the accompanying drawings, it should be noted that various substitutions, modifications, and changes can be made without departing from the scope of the present disclosure which can be understood by those skilled in the art to which the present disclosure pertains. In addition, it should be noted that that such substitutions, modifications and changes are intended to fall within the scope of the appended claims.

## Claims

1. An apparatus comprising:
one or more processors; and
one or more memories storing a machine learning model and commands that cause the one or more processors to perform operations when executed by the one or more processors,
wherein the one or more processors are configured to:
acquire measurement data indicating a state of solder paste printed on a plurality of printed circuit boards (PCBs) by a screen printer;
generate a plurality of input images that correspond one-to-one to the plurality of PCBs and indicate whether the measurement data satisfies a predetermined standard, the plurality of input images including a first input image corresponding to a first PCB and a plurality of second input images corresponding respectively to the PCBs on which the solder paste is sequentially printed before the first PCB; and
determine a type of defect that has occurred in at least one of the screen printer or the first PCB from the first input image and the plurality of second input images based on the machine learning model.

2. The apparatus of Claim 1, wherein the one or more processors are configured to:
generate first data obtained by analyzing the state of the solder paste printed on the plurality of PCBs based on a time-series change between patterns of the first input image and each of the plurality of second input images;
generate second data obtained by analyzing a position of the solder paste printed on the plurality of PCBs based on the patterns of the first input image and each of the plurality of second input images; and
determine the type of defect that has occurred in the at least one of the screen printer or the first PCB based on the first data and the second data.

3. The apparatus of Claim 2, wherein the one or more processors are configured to determine the type of defect that has occurred in the screen printer or the first PCB based on whether a same pattern periodically appears between the first input image and the plurality of second input images, based on the first data.

4. The apparatus of Claim 3, wherein the one or more processors are configured to determine the type of defect that has occurred in the screen printer from the second data based on the machine learning model in response to determining that a defect has occurred in the screen printer.

5. The apparatus of Claim 2, wherein the first data comprises data indicating whether a same pattern appears between the first input image and the plurality of second input images and data indicating a period in which the same pattern appears, and the second data comprises data about shapes of the patterns of the first input image and each of the plurality of second input images.

6. The apparatus of Claim 1, wherein the one or more processors are configured to:
divide the measurement data into a plurality of pieces of data each corresponding to one PCB;
generate a plurality of images indicating whether the solder paste printed on each PCB satisfies the predetermined standard based on the plurality of pieces of divided data; and
generate the plurality of input images by changing the size of the plurality of images to a predetermined size.

7. The apparatus of Claim 1, wherein the one or more processors are configured to determine a first probability of a first defect type occurring in the screen printer or the first PCB and a second probability of a second defect type occurring in the screen printer or the first PCB, based on patterns of the first input image and each of the plurality of second input images.

8. The apparatus of Claim 1, further comprising a communication circuit communicatively connected to a PCB inspector,
wherein the communication circuit is configured to acquire the measurement data indicating the state of the solder paste printed on the plurality of PCBs from the PCB inspector.

9. The apparatus of Claim 1, wherein the type of defect comprises at least one of a squeeze blade defect, a squeeze blade fixation defect, a stencil bottom support defect, a defect due to poor clamp contact and damage, a defect due to neglect of solder paste and poor kneading of solder paste, a defect due to lack of solder paste in a specific area, a defect due to poor contact between stencil and board, a defect in stencil design, or a defect in board design.

10. The apparatus of Claim 1, wherein the one or more processors are configured to train the machine learning model through a plurality of images having at least one pattern determined based on whether the solder paste printed on each of the plurality of PCBs classified according to at least one type of defect of the screen printer satisfies the predetermined standard.

11. The apparatus of Claim 10, wherein the machine learning model is trained based on whether solder paste printed on each of learning PCBs having different sizes and shapes satisfies the predetermined standard.

12. The apparatus of Claim 10, wherein the machine learning model is a transformer model.

13. A method comprising:
acquiring measurement data indicating a state of solder paste printed on a plurality of PCBs by a screen printer;
generating a plurality of input images that correspond one-to-one to the plurality of PCBs and indicate whether the measurement data satisfies a predetermined standard, the plurality of input images including a first input image corresponding to a first PCB and a plurality of second images corresponding respectively to the PCBs on which the solder paste is sequentially printed before the first PCB; and
determining a type of defect that has occurred in at least one of the screen printer or the first PCB from the first input image and the plurality of second input images based on a machine learning model stored in one or more memories.

14. The method of Claim 13, wherein the determining the type of defect comprises:
generating first data obtained by analyzing the state of the solder paste printed on the plurality of PCBs based on a time-series change between patterns of the first input image and each of the plurality of second input images;
generating second data obtained by analyzing a position of the solder paste printed on the plurality of PCBs based on the patterns of the first input image and each of the plurality of second input images; and
determining the type of defect that has occurred in the at least one of the screen printer or the first PCB based on the first data and the second data.

15. The method of Claim 14, wherein the determining the type of defect comprises determining the type of defect that has occurred in the screen printer or the first PCB based on whether a same pattern periodically appears between the first input image and the plurality of second input images, based on the first data.

16. The method of Claim 15, wherein the determining the type of defect comprises determining the type of defect that has occurred in the screen printer from the second data based on the machine learning model in response to determining that a defect has occurred in the screen printer.

17. The method of Claim 14, wherein the first data comprises data indicating whether a same pattern appears between the first input image and the plurality of second input images and data indicating a period in which the same pattern appears, and the second data comprises data about shapes of the patterns of the first input image and each of the plurality of second input images.

18. The method of Claim 13, wherein the determining the type of defect comprises determining a first probability of a first defect type occurring in the screen printer or the first PCB and a second probability of a second defect type occurring in the screen printer or the first PCB, based on patterns of the first input image and each of the plurality of second input images.

19. The method of Claim 13, further comprising training the machine learning model through a plurality of images having at least one pattern determined based on whether the solder paste printed on each of the plurality of PCBs classified according to at least one type of defect of the screen printer satisfies the predetermined standard.

20. A non-transitory computer-readable recording medium recording commands that cause one or more processors to perform operations when executed by one or more processors, the commands causing the one or more processors to perform operations of:
acquiring measurement data indicating a state of solder paste printed on a plurality of PCBs by a screen printer;
generating a plurality of input images that correspond one-to-one to the plurality of PCBs and indicate whether the measurement data satisfies a predetermined standard, the plurality of input images including a first input image corresponding to a first PCB and a plurality of second images corresponding respectively to the PCBs on which the solder paste is sequentially printed before the first PCB; and
determining a type of defect that has occurred in at least one of the screen printer or the first PCB from the first input image and the plurality of second input images based on a machine learning model stored in one or more memories.
